# FASCICULE DE BREVET EUROPEEN

(11) **EP 1 250 711 B1**
(45) Date de publication et mention de la délivrance du brevet: **16.04.2008**
(21) Numéro de dépôt: 01976424.0
(22) Date de dépôt: 12.10.2001
(51) Int. Cl.: H01L 21/00

(54) **DISPOSITIF DE CHAUFFAGE RAPIDE ET UNIFORME D'UN SUBSTRAT PAR RAYONNEMENT INFRAROUGE**
VORRICHTUNG ZUR SCHNELLEN UND GLEICHMÄSSIGEN HEIZUNG EINES HALBLEITERSUBSTRATS DURCH INFRAROTSTRAHLUNG
DEVICE FOR FAST AND UNIFORM HEATING OF A SUBSTRATE WITH INFRARED RADIATION

(30) Priorité: 13.10.2000 FR 0013182
(43) Date de publication de la demande: 23.10.2002
(73) Titulaire: Qualiflow-Therm, 34935 Montpellier (FR)
(72) Inventeur: DUCRET, René, Pierre, F-38360 Sassenage (FR); LAPORTE, Franck, F-38190 Bernin (FR); PIERRET, Benoit, F-38240 Meylan (FR); SEMMACHE, Bachir, BP 7 34935 Montpellier Cédex 9 (FR)
(74) Mandataire: Hecké, Gérard
(86) Numéro de dépôt international: PCT/FR2001/003171
(87) Numéro de publication internationale: WO 2002/031862

(56) Documents cités:
- WO-A-00/30157
- WO-A-00/34986
- WO-A-99/45573
- GB-A- 2 181 458
- US-A- 5 790 751
- US-A- 6 108 491

## Description

### Domaine technique de l'invention

L'invention est relative à un dispositif de chauffage d'un substrat, comprenant des lampes à rayonnement infrarouge destinées à assurer un traitement thermique rapide du substrat à l'intérieur d'une chambre de réaction fermée, laquelle comporte un hublot transparent traversé par ledit rayonnement infrarouge.

### Etat de la technique

Les procédés thermiques rapides de recuit RTP et de dépôt en phase vapeur RTCVD font généralement usage d'un four à rayonnement infrarouge généré par des lampes halogènes. Le substrat, par exemple en silicium dans les technologies de fabrication des produits de la microélectronique, est installé sous atmosphère contrôlée, dans une enceinte fermée, et le rayonnement infrarouge est dirigé sur la face superficielle du substrat à travers un hublot transparent.

Les températures atteintes lors des traitements thermiques, peuvent être élevées, souvent supérieures à 1000°C, avec des vitesses de montée en température susceptibles d'atteindre quelques 100°C/seconde. L'un des paramètres importants du traitement est l'uniformité de température sur toute la surface du substrat traité, étant donné que la présence de gradients thermiques de quelques degrés Celsius entre la zone centrale et la zone périphérique du substrat peut provoquer des différences sur la qualité du substrat, et/ou des défauts d'homogénéités sur les propriétés physico-chimiques des couches présentes à la surface du substrat. L'énergie perdue sur les bords du substrat est plus élevée que pour le centre, ce qui entraîne une température plus basse au bord qu'au centre.

Pour remédier à ces inconvénients dans les procédés thermiques rapides, il a déjà été proposé de compenser cette inégalité de température en utilisant les solutions connues suivantes:
- réflecteur métallique positionné à l'arrière des lampes;
- chauffage des deux faces du substrat avec deux batteries de lampes agencées le long des côtés opposés du réacteur;
- mise en place d'un anneau de garde;
- utilisation d'un suscepteur;
- mise en rotation du substrat sur un plateau tournant;
- association de deux ou plusieurs des solutions précitées.

La mise en oeuvre de ces solutions connues n'a pas permis à ce jour de contrôler parfaitement l'apport d'énergie lumineuse à la surface du substrat en fonction des différentes conditions de traitements thermiques utilisées (recuit, croissance, ou dépôt de couches minces).

Le document US 5 790 751 décrit un système de chauffage à lampes disposées à la verticale, de sorte que l'éclairement de chaque lampe corresponde à un spot. Les lampes sont réparties de manière circulaire en un seul ensemble.

Le document WO 00/34986 décrit une chambre en quartz qui sépare les lampes du substrat.

Le document US 6 108 491 se rapporte à des lampes spot, et non pas des lampes linéaires. Les lampes spot sont disposées de manière circulaire en dessous du substrat installé sur un support chauffant (suscepteur). La deuxième série de lampes est disposée en dessous, mais sur un diamètre plus petit pour couvrir la partie centrale du support chauffant. Un réflecteur circulaire s'étend entre les deux séries de lampes, ce réflecteur circulaire étant destiné à réfléchir et canaliser le rayonnement infrarouge.

Le document WO 00 30157 se rapporte à deux séries de lampes UV avec une disposition sur les deux faces du réacteur, et un montage à 90°.

### Objet de l'invention

L'objet de l'invention consiste à réaliser un dispositif de chauffage à rayonnement infrarouge contrôlé et directionnel, destiné à réaliser un traitement thermique rapide et uniforme de substrats de différentes géométries et dimensions.

Selon l'invention :
- les lampes à infrarouge sont tubulaire et sont réparties sur deux étages superposés et sont prévues à s'étendre d'un même côté du substrat, les lampes de l'étage inférieur étant disposées perpendiculairement par rapport aux lampes de l'étage supérieur,
- le dispositif comporte des moyens de réglage de la puissance d'alimentation par groupes de lampes spécialememt adaptés à assurer un chauffage plus important sur les bords qu'au centre du substrat,
- et un réflecteur est conformé selon une grille de répartition destinée à réfléchir et canaliser le rayonnement infrarouge pour contrôler les ratios de puissance entre les différentes zones de chauffe.

Selon un mode de réalisation préférentiel, la grille de répartition du réflecteur est constituée par un entrecroisement de lames délimitant une pluralité de compartiments de sections variables affectés aux zones de chauffe. La distribution de puissance par zones des deux étages de lampes halogènes, et la présence du réflecteur intercalaire permettent d'obtenir un chauffage uniforme du substrat, indépendamment de sa géométrie et de ses dimensions.

Selon une caractéristique de l'invention, les lames sont croisées à angle droit, et sont réalisées en un matériau ayant un indice de réflexion optimum pour réfléchir les rayons infrarouges. Le matériau des lames peut être métallique (acier ou aluminium) ou non métallique (céramique, zircon).

Les lampes à rayonnement infrarouge sont des lampes halogènes, et chaque étage comporte avantageusement le même nombre de lampes tubulaires échelonnées à intervalles réguliers en s'étendant parallèlement l'une à l'autre.

Le réflecteur peut être intercalé entre l'étage inférieur des lampes et le hublot, ou être directement imbriqué entre les zones des lampes, de manière à recouvrir la hauteur des deux séries de lampes.

### Description sommaire des dessins

D'autres avantages et caractéristiques ressortiront plus clairement de la description qui va suivre d'un mode de réalisation de l'invention donné à titre d'exemple non limitatif, et représenté aux dessins annexés dans lesquels:
- la figure 1 est une vue schématique d'un réacteur équipé du dispositif de chauffage selon l'invention;
- la figure 2 montre une vue en plan de la figure 1;
- la figure 3 représente le tableau de distribution de puissance par zones de chauffe;
- la figure 4 illustre une vue en perspective du réflecteur associé à un dispositif de chauffage à douze lampes par étage ;
- la figure 5 est une vue identique de la figure 4 d'une variante de réalisation.

### Description d'un mode de réalisation préférentiel

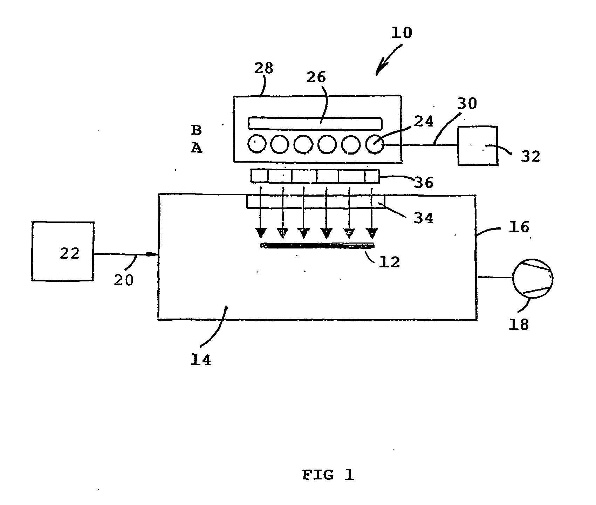

Sur les figures 1 à 3, un dispositif de chauffage 10 à rayonnement infrarouge est utilisé dans les procédés thermiques rapides mis en oeuvre dans les technologies de fabrication des substrats de la microélectronique. D'autres applications sont possibles pour réaliser des micro-capteurs, et des panneaux d'énergie solaire.

Le substrat 12, par exemple en silicium, est disposé dans la zone médiane d'une chambre de réaction 14 délimitée par une enceinte 16 fermée, laquelle est réalisée en acier inoxydable ou en quartz. Des moyens de pompage 18 sont raccordés à l'enceinte 16 pour travailler à la pression atmosphérique, ou abaisser la pression interne de la chambre de réaction 14 jusqu'à des vides secondaires.

Un flux de gaz 20 neutre ou réactif peut être introduit par des moyens d'injection 22 dans la chambre de réaction 14 pour réaliser des traitements sous atmosphère inerte ou réactive, notamment de recuit du substrat 12, de dépôt de couches minces à la surface exposée du substrat 12 (technique CVD de dépôt sous vapeur chimique), de modification des propriétés physico-chimiques de la surface, etc..

Selon l'invention, le dispositif de chauffage 10 à rayonnement infrarouge permet d'obtenir un traitement thermique rapide et uniforme de toute la surface exposée du substrat 12. Le dispositif de chauffage 10 est composé de deux séries de lampes halogènes 24, 26 tubulaires réparties sur deux étages A et B superposés à l'intérieur d'un logement 28. Le premier étage A inférieur comporte une pluralité de lampes 24 halogènes, par exemple six sur les figures 1 à 3, échelonnées à intervalles réguliers et s'étendant parallèlement l'une à l'autre dans un même plan. Le deuxième étage B supérieur est doté d'un nombre identique de lampes 26 disposées perpendiculairement par rapport aux lampes 24 du premier étage A, et dans un même plan parallèle au premier.

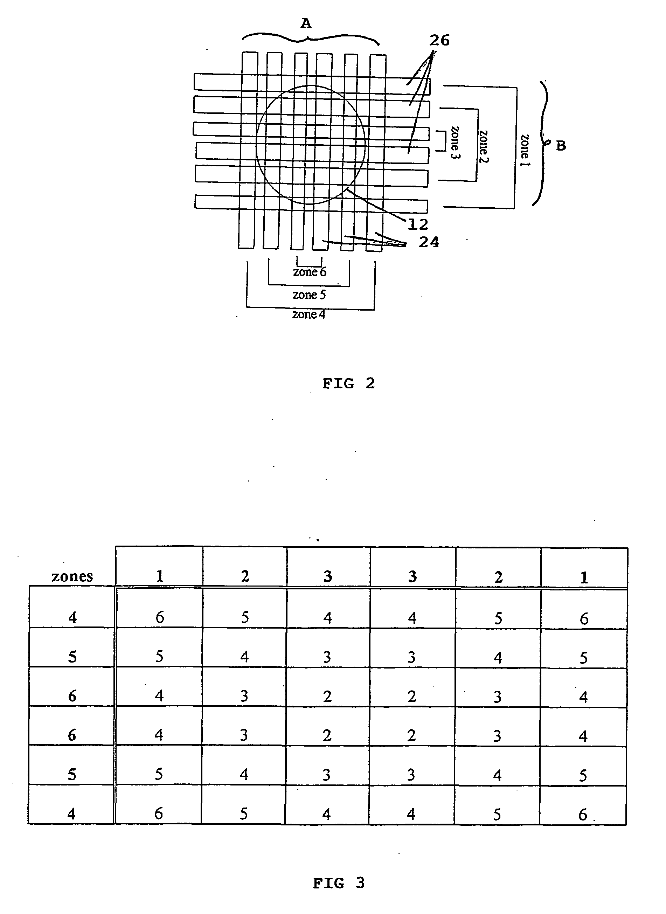

Les lampes halogènes 24, 26 sont alimentées par groupes en étant branchées à un circuit d'interconnexion 30 relié à un dispositif d'alimentation 32 à tension ajustable pour le réglage de la puissance électrique rayonnée dans différentes zones de chauffe. En référence à la figure 2, les six lampes 26 de l'étage B sont alimentées selon trois zones 1,2,3. A titre d'exemple, la zone 1 est définie par les deux lampes 26 d'extrémités, la zone 2 par les deux lampes 26 intermédiaire, et la zone 3 par les deux lampes 26 internes juxtaposées. D'une manière similaire, les six lampes 24 de l'étage A sont alimentées selon trois autres zones 4, 5, 6 orthogonales par rapport aux zones 1, 2 3. La zone 4 est délimitée par les deux lampes 24 d'extrémités, la zone 5 par les deux lampes 24 intermédiaires, et la zone 6 par les deux lampes 24 internes.

Le réglage de la puissance dans chacune des zones 1 à 6 permet de compenser les effets de gradients thermiques radiaux liés aux pertes thermiques par convection sur les bords du substrat 12. Le profil de puissance dans les différentes zones détermine l'image de la température à la surface du substrat 12. En appliquant une puissance plus élevée sur les zones périphériques par rapport aux zones centrales, on obtient un profil uniforme de la température sur tout le substrat 12 suite à la compensation des pertes thermiques le long des bords du substrat 12. La structure illustrée sur la figure 2 permet d'obtenir une distribution de puissance :
- Puisance zone 1: 3
- Puisance zone 2: 2
- Puisance zone 3: 1
- Puisance zone 4: 3
- Puisance zone5: 2
- Puisance zone6: 1
   symbolisée dans le tableau de la figure 3. On remarque que la distribution de puissance illustrée dans ce tableau, permet ainsi de réaliser un chauffage plus important sur les bords qu'au centre du substrat 12.

L'enceinte 16 de la chambre de réaction 14 est pourvue d'un hublot 34 transparent , par exemple en quartz, laissant passer le rayonnement infrarouge émis par les lampes halogènes 24, 26 depuis l'extérieur de l'enceinte 16. Dans l'intervalle situé entre le dispositif de chauffage 10 et le hublot 34, est agencé un réflecteur 36 , destiné à réfléchir le rayonnement infrarouge pour contrôler les ratios de puissance entre les différentes zones de chauffe, étant donné que la puissance nécessaire pour compenser les écarts thermiques entre le centre et les bords du substrat 12 varie avec la température du substrat 12.

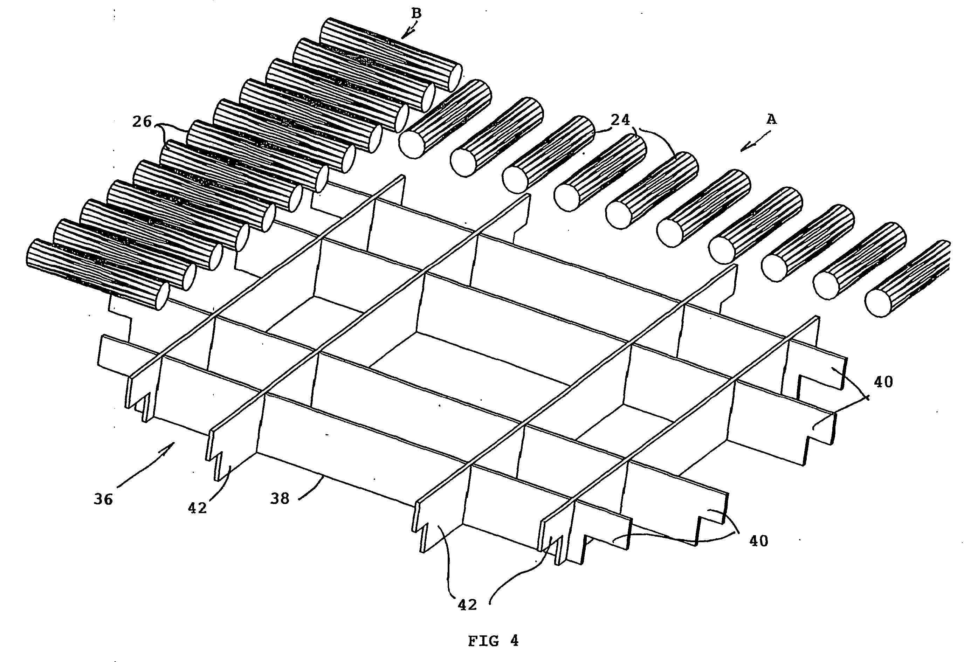

En référence à la figure 4, chaque étage A et B comprend douze lampes (deux lampes 24 étant cachées à gauche de l'étage A). Le réflecteur 36 disposé sous le logement des lampes 24, 26, est conformé selon une grille de répartition 38 constituée par un entrecroisement de quatre lames longitudinales 40 et quatre lames transversales 42, de manière à définir différents compartiments quadrangulaires ouverts du côté du hublot 34 et du côté des lampes 24, 26. Les compartiments présentent des sections variables affectées à chacune des zones de chauffe, permettant ainsi de canaliser l'énergie lumineuse émise par les différentes zones d'éclairement des lampes 24, 26 vers les zones correspondantes du substrat 12.

Les lames 40, 42 croisées du réflecteur 36 sont réalisées en un matériau ayant un indice de réflexion optimum pour réfléchir les rayons infrarouge. Le matériau peut être non métallique, par exemple de la céramique ou à base de zircon. On peut également faire usage d'une grille en matière métallique, par exemple en acier, aluminium, avec éventuellement un revêtement superficiel en or ou en argent.

Dans le cas d'un matériau métallique, le réflecteur 36 peut être avantageusement refroidi par un fluide caloporteur.

La compensation par zones de chauffe est ainsi contrôlée avec précision étant donné que les zones d'éclairement du substrat 12 sont parfaitement délimitées par le réflecteur 36 pour réduire au maximum les effets d'interférences entre zones.

La distribution de puissance par zones des deux étages de lampes 24, 26 halogènes, et la présence du réflecteur 36 intercalaire permettent d'obtenir un chauffage uniforme du substrat 12, indépendamment de sa géométrie et de ses dimensions.

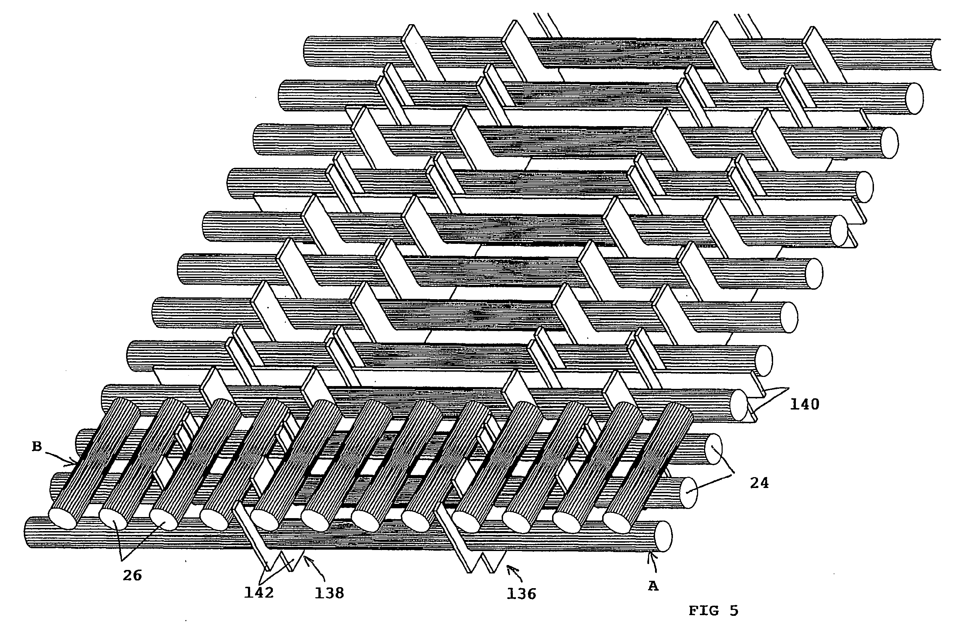

Selon la variante de la figure 5, les lames 142, 144 constitutives de la grille 138 du réflecteur 136 sont imbriquées entre les lampes 24, 26 de manière à recouvrir la hauteur des deux séries A et B. Il en résulte que les zones des lampes 24, 26 sont complètement encadrées dans les écrans.

## Revendications

1. Dispositif de chauffage d'un substrat (12), comprenant des lampes à rayonnement infrarouge (24, 26) destinées à assurer un traitement thermique rapide du substrat à l'intérieur d'une chambre de réaction (14) fermée, laquelle comporte un hublot (34) transparent traversé par ledit rayonnement infrarouge,
dans lequel :
- les lampes à infrarouge (24, 26) sont tubulaires et sont réparties sur deux étages (A, B) superposés et sont prévues à s'étendre d'un même côté du substrat (12), les lampes (24) de l'étage inférieur (A) étant disposées perpendiculairement par rapport aux lampes (26) de l'étage supérieur (B),
- le dispositif comporte des moyens de réglage de la puissance d'alimentation par groupes de lampes (24, 26) spécialement adaptés à assurer un chauffage plus important sur les bords qu'au centre du substrat (12),
- et un réflecteur (36, 136) est conformé selon une grille de répartition (38, 138) destinée à réfléchir et canaliser le rayonnement infrarouge pour contrôler les ratios de puissance entre les différentes zones de chauffe.

2. Dispositif de chauffage selon la revendication 1, **caractérisé en ce que** la grille de répartition (38, 138) du réflecteur (36, 136) est constituée par un entrecroisement de lames (40, 42; 140, 142) délimitant une pluralité de compartiments de sections variables affectés aux zones de chauffe, ladite grille étant agencée soit entre les lampes (24, 26) et le hublot (34), soit imbriquée entre lesdites lampes.

3. Dispositif de chauffage selon la revendication 2, **caractérisé en ce que** les lames (40, 42 ; 140, 142) sont croisées à angle droit, et sont réalisées en un matériau ayant un indice de réflexion optimum pour réfléchir les rayons infrarouges.

4. Dispositif de chauffage selon la revendication 2 ou 3, **caractérisé en ce que** les lames (40, 42; 140, 142) du réflecteur (36, 136) sont réalisées en un matériau non métallique, notamment en céramique ou à base de zircon.

5. Dispositif de chauffage selon la revendication 2 ou 3, **caractérisé en ce que** les lames (40, 42; 140, 142) du réflecteur (36, 136) sont réalisées en un matériau métallique, par exemple en acier, aluminium, ou ayant un revêtement superficiel en or ou en argent.

6. Dispositif de chauffage selon la revendication 5, **caractérisé en ce que** le réflecteur (36, 136) est refroidi par un fluide caloporteur.

7. Dispositif de chauffage selon l'une des revendications 1 à 6, **caractérisé en ce que** les lampes (24, 26) à rayonnement infrarouge sont des lampes halogènes.

8. Dispositif de chauffage selon la revendication 7, **caractérisé en ce que** chaque étage (A,B) comporte le même nombre de lampes (24, 26) tubulaires échelonnées à intervalles réguliers en s'étendant parallèlement l'une à l'autre.

9. Réacteur pour un procédé thermique rapide équipé d'un dispositif de chauffage selon l'une des revendications 1 à 8.

## Claims

1. A heating device of a substrate (12), comprising infrared radiation lamps (24, 26) designed to perform rapid thermal processing of the substrate inside a closed reaction chamber (14) that comprises a transparent window (34) wherethrough said infrared radiation passes,
dans lequel
- the infrared lamps (24, 26) are tubular and arranged in two superposed stages (A, B) and designed to be arranged on a single side of the substrate (12), the lamps (24) of the lower stage (A) being arranged perpendicularly with respect to the lamps (26) of the upper stage (B),
- the device comprises means for adjusting the supply power by groups of lamps (24, 26) especially adapted to ensure greater heating on the edges than in the centre of the substrate (12),
- and a reflector (36, 136) in the form of a distribution grid (38, 138) is designed to reflect and channel the infrared radiation to control the power ratios between the different heating zones.

2. The heating device according to claim 1, **characterized in that** the distribution grid (38, 138) of the reflector (36, 136) is formed by a criss-cross arrangement of strips (40, 42; 140, 142) bounding a plurality of compartments of variable cross-sections assigned to the heating zones, said grid being arranged either between the lamps (24, 26) and the window (34) or fitted between said lamps.

3. The heating device according to claim 2, **characterized in that** the strips (40, 42; 140, 142) are criss-crossed at right angles and are made of a material having an optimum reflection index to reflect the infrared rays.

4. The heating device according to claim 2 or 3, **characterized in that** the strips (40, 42; 140, 142) of the reflector (36, 136) are made of a non-metallic material, in particular ceramic or zircon-based.

5. The heating device according to claim 2 or 3, **characterized in that** the strips (40, 42; 140, 142) of the reflector (36, 136) are made of a metallic material, for example steel, aluminium, or a material having a superficial gold or silver coating.

6. The heating device according to claim 5, **characterized in that** the reflector (36, 136) is cooled by a cooling fluid.

7. The heating device according to one of the claims 1 to 6, **characterized in that** the infrared lamps (24, 26) are halogen lamps.

8. The heating device according to claim 7, **characterized in that** each stage (A, B) comprises the same number of tubular lamps (24, 26) staggered at regular intervals and extending parallel to one another.

9. A reactor for rapid thermal processing equipped with a heating device according to one of the claims 1 to 8.

## Patentansprüche

1. Vorrichtung zum Erwärmen eines Substrats (12), die Infrarotlampen (24, 26) umfasst, die dazu bestimmt sind, eine Schnellwärmebehandlung des Substrats innerhalb einer geschlossenen Reaktionskammer (14) sicherzustellen, die ein transparentes Fenster (34) hat, das von der Infrarotstrahlung durchquert wird, bei der
- die Infrarotlampen (24, 26) röhrenförmig und auf zwei übereinander angeordneten Ebenen (A, B) verteilt und vorgesehen sind, sich auf ein und derselben Seite des Substrats (12) zu erstrecken, wobei die Lampen (24) der unteren Ebene (A) lotrecht zu den Lampen (26) der oberen Ebene (B) angeordnet sind,
- die Vorrichtung Mittel zur Regulierung der Versorgungsleistung pro Gruppen von Lampen (24, 26) umfasst, die besonders ausgestattet sind, um eine stärkere Erwärmung an den Rändern des Substrats (12) als in dessen Mitte sicherzustellen,
- und bei der ein Reflektor (36, 136) in Form eines Verteilungsgitters (38, 138) vorgesehen und dazu bestimmt ist, zur Steuerung der Leistungsverhältnisse zwischen den einzelnen Erwärmungszonen die Infrarotstrahlung zu reflektieren und zu kanalisieren.

2. Erwärmungsvorrichtung nach Anspruch 1, **dadurch gekennzeichnet, dass** das Verteilungsgitter (38, 138) des Reflektors (36, 136) von überkreuz angeordneten Lamellen (40, 42; 140, 142) gebildet wird, die eine Mehrzahl von Fächern unterschiedlichen Querschnitts bilden, die den Erwärmungsbereichen zugeordnet sind, wobei das Gitter entweder zwischen den Lampen (24, 26) und dem Fenster (34) oder zwischen den Lampen verschachtelt angeordnet ist.

3. Erwärmungsvorrichtung nach Anspruch 2, **dadurch gekennzeichnet, dass** die Lamellen (40, 42; 140, 142) sich im rechten Winkel kreuzen und aus einem Material bestehen, das einen optimalen Reflexionskoeffizienten zur Reflexion der Infrarotstrahlen aufweist.

4. Erwärmungsvorrichtung nach Anspruch 2 oder 3, **dadurch gekennzeichnet, dass** die Lamellen (40, 42; 140, 142) des Reflektors (36, 136) aus einem nichtmetallischen Material bestehen, insbesondere aus einem keramischen oder einem Material auf Zirkonbasis.

5. Erwärmungsvorrichtung nach Anspruch 2 oder 3, **dadurch gekennzeichnet, dass** die Lamellen (40, 42; 140, 142) des Reflektors (36, 136) aus einem metallischen Material bestehen, beispielsweise aus Stahl, Aluminium, oder mit einer Oberflächenbeschichtung aus Gold oder Silber versehen sind.

6. Erwärmungsvorrichtung nach Anspruch 5, **dadurch gekennzeichnet, dass** der Reflektor (36, 136) mittels eines Kühlfluids gekühlt wird.

7. Erwärmungsvorrichtung nach einem der Ansprüche 1 bis 6, **dadurch gekennzeichnet, dass** die Infrarotlampen (24, 26) Halogenlampen sind.

8. Erwärmungsvorrichtung nach Anspruch 7, **dadurch gekennzeichnet, dass** jede Ebene (A, B) die gleiche Anzahl röhrenförmiger Lampen (24, 26) aufweist, die in gleichmäßigen Abständen voneinander angeordnet sind und sich parallel zueinander erstrecken.

9. Reaktor für ein Schnellerwärmungsverfahren, das mit einer Erwärmungsvorrichtung nach einem der Ansprüche 1 bis 8 ausgestattet ist.
